# EUROPÄISCHE PATENTSCHRIFT

(11) **EP 2 264 470 B1**
(45) Veröffentlichungstag und Bekanntmachung des Hinweises auf die Patenterteilung: **04.11.2015**
(21) Anmeldenummer: 10011554.2
(22) Anmeldetag: 02.12.2004
(51) Int. Cl.: G01R 22/06

(54) **Anschlusssystem für Stromzähler**
Connection system for electricity meters
Système de raccordement pour compteurs d'électricité

(30) Priorität: 16.12.2003 DE 10359139
(43) Veröffentlichungstag der Anmeldung: 22.12.2010
(62) Teilanmeldung aus: 04028522.3
(73) Patentinhaber: Hager Electro GmbH & Co. KG, 66440 Blieskastel (DE)
(72) Erfinder: Kelaiditis, Konstantin, Dr.-Ing., 66386 St. Ingbert (DE); Zimmermann, Michael, 66130 Saarbrücken (DE); Clemens, Guntram, Dr.-Ing., 31787 Hameln (DE)
(74) Vertreter: Nuss, Laurent

(56) Entgegenhaltungen:
- DE-A1- 4 116 218
- DE-U1- 20 216 393
- DE-U1- 29 703 981
- US-A- 2 086 495
- US-A- 2 412 558
- US-A- 3 628 097
- US-A- 5 586 913
- US-A- 5 704 804
- US-A1- 2002 030 964
- US-B1- 6 475 028

## Beschreibung

Die Erfindung betrifft ein Anschlusssystem für elektronische Stromzähler gemäß Oberbegriff des Anspruchs 1.

Die hier einbezogenen Patentanmeldungen 102 61 206.4, 103 13 999.0, 103 23 161.7, 103 23 160.9 und 103 24 355.0 beschreiben Anschlussvorrichtungen für elektronische Stromzähler, deren Verbindungs- und Anschlusselemente sich von herkömmlichen Zählern unterscheiden. Gemäß der 102 61 206.4 ist ein Zähler über einen Adapter an eine Zählertragplatte für herkömmliche Zähler anschließbar, wobei der Adapter am Zählerkreuz der Zählertragplatte befestigt wird.

Die US 5 586 913 beschreibt ein Anschlusssystem mit einer Aufnahmebaugruppe, die einen Stecksockel für die Aufnahme eines auf den Stecksockel aufsteckbaren Stromzählers umfasst. Die Aufnahmebaugruppe ist in ihrer Gesamtheit über eine Montageplatte an einer Montagewand anbringbar, von einem Gehäuse der Aufnahmebaugruppe stehen die Enden innerhalb der Aufnahmebaugruppe mit Steckerelementen verbundener starrer Leiter vor, die mit einer angrenzend an die Aufnahmebaugruppe angeordneten Steckeranschlussleiste verbindbar sind.

Der vorliegenden Erfindung liegt die Aufgabe zugrunde, ein neues Anschlusssystem für Stromzähler zu schaffen, das insbesondere den sich für elektronische Stromzähler stellenden Anforderungen gerecht wird.

Das diese Aufgabe lösende Anschlusssystem für elektronische Stromzähler ist dadurch gekennzeichnet, dass die Basisplattform durch einen Abschnitt einer Zählerschrankinstallation gebildet ist, die je einen weiteren Abschnitt oberhalb und unterhalb der Basisplattform aufweist, wobei die weiteren Abschnitte einen oberen und einen unteren Anschlussraum bilden, dass die Aufnahmebaugruppe mit hinter der Basisplattform zu verlegenden und in die beiden Anschlussröume zu führenden Anschlussleitem vorgefertigt ist, und dass es sich bei den Anschlussleitern um starre, entsprechend der Anschlussgeometrie vorgeformte Anschlussleiter handelt.

Gemäß der Erfindung ist ein Anschlusssystem für Stromzähler derart modular aufgebaut, dass der Anschluss des Stromzähler an die Plattform über eine gesonderte Baugruppe erfolgt. Wenn gemäß einer Ausführungsform der Erfindung die Basisplattform mehrere Sitze für die Aufnahme einer solchen Aufnahmebaugruppe aufweist, brauchen bei Nichtnutzung von Sitzen nicht alle Ankopplungselemente vorhanden zu sein. Erst bei einer Nachrüstung werden diese Elemente ergänzt.

Zweckmäßig sind die Anschlussleiter nicht sichtbar hinter der Basisplattform verlegt. Die Basisplattform kann einen zur Bildung eines Sitzes ausbrechbaren oder abnehmbaren Teil aufweisen, wobei ein Sitz z.B. durch einen Durchbruch oder eine Vertiefung in der Plattform gebildet sein kann.

In einer besonders bevorzugten Ausführungsform der Erfindung ist die Aufnahmebaugruppe sowohl von der Rückseite als auch der Vorderseite der Basisplattform her an der Basisplattform montierbar. Zweckmäßig ist eine einrastende Steckverbindung vorgesehen, die eine schnelle Montage ohne Werkzeug ermöglicht.

Die Möglichkeit zur Montage der Aufnahmebaugruppe von der Rückseite der Plattform her ist für die Produktion vorteilhaft, insbesondere dann, wenn gemäß einer Ausführungsform der Erfindung die Aufnahmebaugruppe mit in Anschlussräume zu führenden Anschlussleitern vorgefertigt ist. Die hinter der Basisplattform verlegten Anschlussleiter brauchen dann nicht eingefädelt zu werden. Die Montagemöglichkeit von der Vorderseite her erleichtert Nachrüstungen von Zählern und Aufnahmebaugruppen wie auch den Austausch von Zählern. z.B. zur Umstellung auf einen höheren Grenzstrom.

In weiterer Ausgestaltung der Erfindung kann es sich bei den Anschlussleitern um wenigstens teilweise starre, der Anschlussgeometrie entsprechend vorgeformte Leiter handeln. Letztere lassen sich nur montieren, wenn auch die Montagemöglichkeit von der Rückseite der Basisplattform her gegeben ist.

Die mit der Aufnahmebaugruppe vorgefertigten starren Leiter können mit einer Klemmleiste, insbesondere einer Hauptleitungsabzweigklemme verbunden sein, wobei die Klemmleiste entweder an die Basisplattform oder/und eine Hutprofilschiene in einem Anschlussraum koppelbar sein kann.

Die starren Anschlussleiter können ferner ein mit einem weiteren Anschlussleiter verbindbares Kontaktstück der genannten Klemmleiste bilden, was die Konstruktion der Klemmleiste vorteilhaft vereinfacht.

Die starren Leiter können unmittelbar in Kontakt mit einem Kontaktstück des Stromzählers stehen. Gesonderte Anschlusskontaktstücke für die Anschlussleiter an der Aufnahmebaugruppe sind dann überflüssig.

Die Aufnahmebaugruppe lässt sich sowohl mit nach oben als auch nach unten von der Baugruppe wegführenden Leitern vorfertigen.

In weiterer Ausgestaltung der Erfindung ist ein Nullleiter ununterbrochen durch die Aufnahmebaugruppe hindurch verlegt und innerhalb der Aufnahmebaugruppe, ggf. durch eine Messerkontaktierung, angeschlossen. Auch hierbei kann es sich um einen wenigstens teilweise starren Leiter handeln, der unmittelbar in Kontakt mit einem Kontaktstück des Zählers kommt. Gesonderte Anschlusselemente entfallen.

Der wenigstens teilweise starre Nullleiter kann einen ggf. verformten Abschnitt aufweisen, mit dem er federnd gegen das Kontaktstück des Stromzählers anliegt.

In weiterer vorteilhafter Ausgestaltung der Erfindung sind Einrichtungen zur Sicherung der Aufnahmebaugruppe in ihrer Montagestellung auf der Basisplattform vorgesehen. Eine solche Sicherung kann durch einen Teil des Stromzählers, z.B. ein Verhakungselement, gebildet sein. Ein die Steckverbindung bildendes Element umfasst zweckmäßig Einrichtungen zur Demontage der Aufnahmebaugruppe, wobei das Element zweckmäßig durch den in seiner Betriebsstellung plombierten Stromzähler versperrt und daher nicht zugänglich ist.

Auch ein die Rastverbindung bildendes Element kann Einrichtungen zur Lösung der Rastverbindung aufweisen.

Die Erfindung soll nun anhand von Ausführungsbeispielen und der beiliegenden, sich auf diese Ausführungsbeispiele beziehenden Zeichnungen näher erläutert werden. Es zeigen:
- Fig. 1: eine Schemadarstellung einer Zählerschrankinstallation mit einem Anschlusssystem gemäß der Erfindung,
- Fig. 2: eine schematische Querschnittsansicht A-A gemäß einem ersten Ausführungsbeispiel für ein Anschlusssystem nach der Erfindung,
- Fig. 3: eine dem Anschlusssystem von Fig. 2 zugehörige Basisplattform vor der Installation eines Stromzählers.
- Fig. 4: Details des Anschlusssystems von Fig. 2 und 3,
- Fig. 5: ein zweites Ausführungsbeispiel für ein Anschlusssystem nach der Erfindung, und
- Fig. 6: einen direkten Anschluss eines Nullleiters an ein Kontaktstück eines Stromzählers.

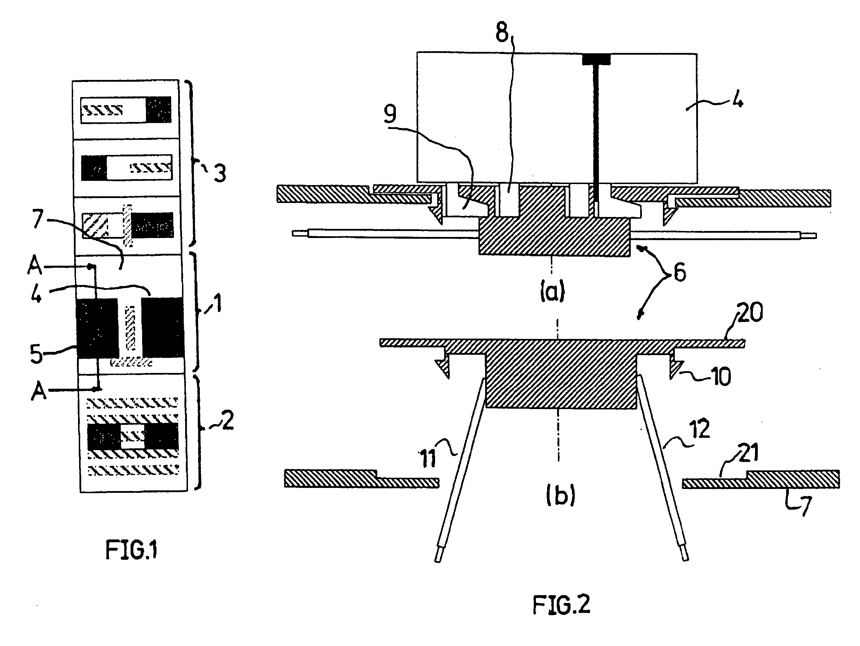

Eine in Fig. 1 gezeigte Zählerschrankinstallation weist einen ein Anschlusssystem für Stromzähler enthaltenden Abschnitt 1 sowie einen unteren und oberen Anschlussraum bildende Abschnitte 2 und 3 auf.

In dem Abschnitt 1 bestehen in dem betrachteten Fall Anschlussmöglichkeiten für zwei Stromzähler 4 und 5.

Aus der dem Schnitt A-A von Fig. 1 entsprechenden Darstellung von Fig. 2 ist erkennbar, dass der Stromzähler 4 mit einer Aufnahmebaugruppe 6 verbindbar ist, die ihrerseits mit einer Basisplattform 7 verbunden werden kann.

Während der Stromzähler 4 über von seiner Rückseite vorstehende Kontaktstücke 8 elektrisch und über Hakenelemente 9 mechanisch mit der Aufnahmebaugruppe 6 verbunden werden kann, ist die Aufnahmebaugruppe 6 auf die Basisplattform 7 aufsteckbar, wobei hinterschnittene Rastnasen 10 an der Basisplattform einrasten und Verlängerungen 20 der Aufnahmebaugruppe 6 in Randeinsenkungen 21 der Basisplattform eingreifen.

Zur elektrischen und mechanischen Verbindung mit der Aufnahmebaugruppe 6 ist der Zähler 4 parallel zur Basisplattform zu verschieben, wobei die Kontaktstücke 8 in elektrischen Kontakt mit innerhalb der Aufnahmebaugruppe vorgesehenen Anschlusselementen kommen und die Hakenelemente 9 Teile des Gehäuses der Aufnahmebaugruppe 6 hintergreifen, so dass der Zähler in Richtung senkrecht zur Basisplattform nicht mehr von der Aufnahmebaugruppe 6 abhebbar ist.

Die Aufnahmebaugruppe 6 ist komplett vorgefertigt mit hinter der Basisplattform 7 zu verlegenden, flexiblen Anschlussleitern 11 und 12, wobei die Anschlussleiter 11 in den oberen Anschlussraum und die Leiter 12 in den unteren Anschlussraum zu führen sind.

Für den Anschluss des Zählers 5 ist ein dem Anschlusssystem von Fig. 2 entsprechendes System vorgesehen.

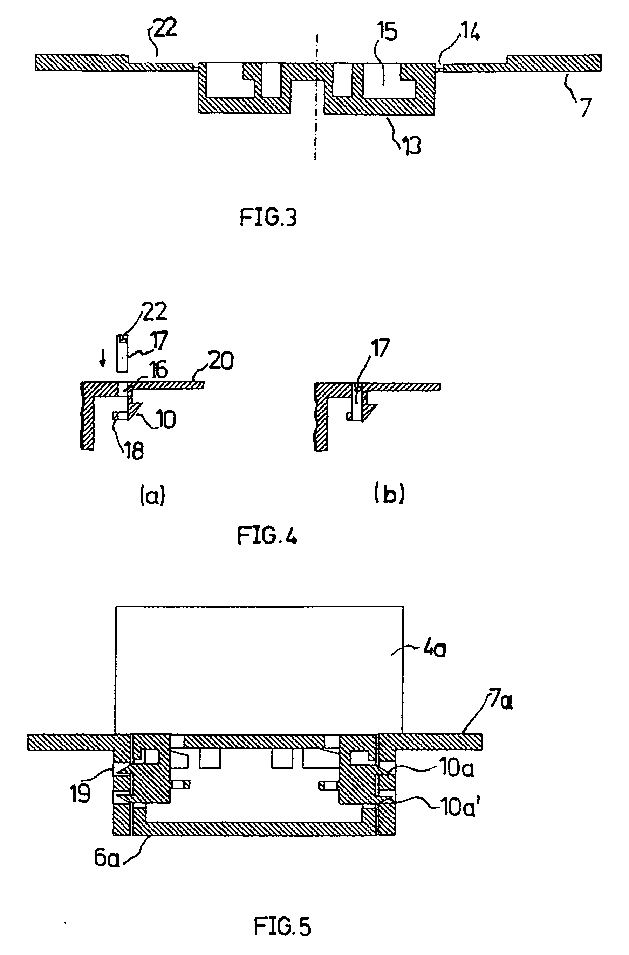

Wie aus Fig. 3 hervorgeht, weist die Basisplattform 7 ein plattenartiges Teil 13 auf, das über Schwachstellen 14 mit der übrigen Basisplattform verbunden und zur Bildung eines Sitzes für den Zähler 4 bzw. 5 aus der Basisplattform 7 ausbrechbar ist. In dem Teil 13 vorgesehene Räume 15 dienen einerseits der Meidung von Materialhäufungen und können andererseits vor Installation eines Stromzählers zur Unterbringung von Teilen, ggf. Verbindungselementen und dergleichen, genutzt werden.

Aus Fig. 4 gehen in Fig. 2 und 3 nicht sichtbare Details hervor. An wenigstens einer der Rastnasen 10 ist ein Durchgang 16 für die Aufnahme eines Sicherungsstifts 17 gebildet, welcher verhindert, dass sich die Rastnasen verbiegen und sich die Aufnahmebaugruppe auf ihrer eingerasteten Steckverbindung mit der Basisplattform 7 lösen kann. Wie Fig. 2a erkennen lässt, ist dieser Sicherungsstift 17 durch den in seiner Betriebslage zu plombierenden Zähler 4 abgedeckt und daher nicht zugänglich. Zur Demontage der Aufnahmebaugruppe 6 von der Basisplattform 7 kann ein einen Teil des Durchgangs 16 bildender Ansatz 18 an der Rastnase 10 dazu verwendet werden, die Rastnase aus ihrer Verhakungsstellung mit der Basisplattform 7 zu lösen, indem z.B. in den betreffenden Abschnitt des Durchgangs 16 ein Werkzeug eingeführt wird. Eine gestufte Ausnehmung 22 am Sicherungsstift kann zum Herausziehen des Stifts aus dem Durchgang 16 genutzt werden.

Es wird nun auf Fig. 5 Bezug genommen, wo gleiche oder gleichwirkende Teile mit derselben Bezugszahl wie in Fig. 2 und 3 bezeichnet sind, wobei der betreffenden Bezugszahl der Buchstabe a beigefügt ist.

Eine kastenartige Aufnahmebaugruppe 6a weist mehrere Paare vorstehender Rastnasen 10a und 10a' auf, die in Ausnehmungen 19 in einer Abwinklung an einer Basisplattform 7a eingreifen. Wie Fig. 5 erkennen lässt, weisen die Rastnasen in entgegengesetzten Richtungen geneigte Schrägen auf, so dass die Aufnahmebaugruppe 6 sowohl von der Vorderseite der Plattform 7a her als auch von deren Rückseite aus auf die Basisplattform aufsteckbar sind.

Die Montage des Zählers 4a an der Aufnahmebaugruppe erfolgt in gleicher Weise wie bei dem Ausführungsbeispiel von Fig. 2.

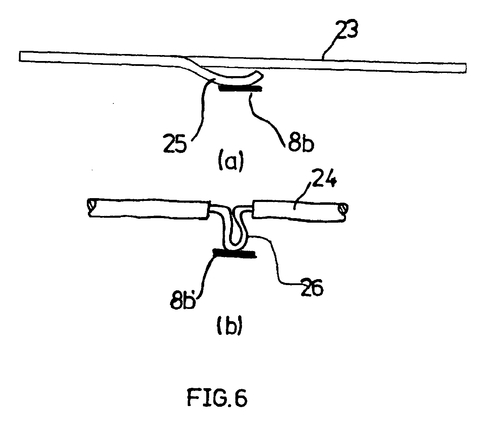

Fig. 6 zeigt durch eine Baugruppe hindurch verlegte Nullleiter 23 und 24. Eine ausgebogene Nase 25 des Leiters 23 liegt federnd gegen ein Kontaktstück 8b eines Stromzählers an.

Der in Fig. 6b gezeigte Leiter 24 ist flexibel und liegt mit einer Schleife 26 gegen ein Kontaktstück 8b' eines Stromzählers an.

## Patentansprüche

1. Anschlusssystem für elektronische Stromzähler (4,5) mit einer Basisplattform (7) und einer an der Basisplattform (7) als Gesamtheit montierbaren Aufnahmebaugruppe (6) für den Stromzähler (4,5), wobei die Aufnahmebaugruppe (6) sämtliche zur elektrischen und mechanischen Ankopplung des Stromzählers (4,5) erforderlichen Elemente aufweist,
**dadurch gekennzeichnet,**
**dass** die Basisplattform (7) durch einen Abschnitt (1) einer Zählerschrankinstallation gebildet ist, die je einen weiteren Abschnitt (2,3) oberhalb und unterhalb der Basisplattform (7) aufweist, wobei die weiteren Abschnitte (2,3) einen oberen und einen unteren Anschlussraum bilden, dass die Aufnahmebaugruppe (6) mit hinter der Basisplattform (7) zu verlegenden und in die beiden Anschlussräume zu führenden Anschlussleitern (11,12) vorgefertigt ist, und dass es sich bei den Anschlussleitem (11,12) um starre, entsprechend der Anschlussgeometrie vorgeformte Anschlussleiter (11,12) handelt.

2. System nach Anspruch 1,
**dadurch gekennzeichnet,**
**dass** an der Basisplattform ein Sitz oder mehrere Sitze für die Aufnahme jeweils einer Aufnahmebaugruppe (6) gebildet ist bzw. sind.

3. System nach Anspruch 1 oder 2,
**dadurch gekennzeichnet,**
**dass** die Basisplattform (7) einen zur Bildung eines Sitzes ausbrechbaren oder abnehmbaren Teil (13) aufweist.

4. System nach einem der Ansprüche 1 bis 3,
**dadurch gekennzeichnet,**
**dass** die Aufnahmebaugruppe (6,6a) von der Rückseite oder/und der Vorderseite der Basisplattform (7,7a) her an der Basisplattform montierbar ist.

5. System nach einem der Ansprüche 1 bis 4,
**dadurch gekennzeichnet,**
**dass** die Aufnahmebaugruppe (6) auf die Basisplattform (7), vorzugsweise einrastend, aufsteckbar ist.

6. System nach einem der Ansprüche 1 bis 5,
**dadurch gekennzeichnet,**
**dass** Einrichtungen (16,17) zur Sicherung der Aufnahmebaugruppe (6) in ihrer Montagestellung auf der Basisplattform (7) vorgesehen sind.

7. System nach einem der Ansprüche 1 bis 6,
**dadurch gekennzeichnet,**
**dass** ein die Sicherung bildendes Element Einrichtungen (18) zur Demontage der Aufnahmebaugruppe umfasst.

8. System nach einem der Ansprüche 5 bis 7,
**dadurch gekennzeichnet,**
**dass** ein die Rastverbindung bildendes Element (10) Einrichtungen (18) zur Lösung der Rastverbindung aufweist.

9. System nach Anspruch 7 oder 8,
**dadurch gekennzeichnet,**
**dass** das Element (10) durch den Stromzähler (4) versperrt ist.

10. System nach einem der Ansprüche 1 bis 9,
**dadurch gekennzeichnet,**
**dass** die starren Leiter der vorgefertigten Aufnahmebougruppe mit einer Klemmleiste, insbesondere Hauptleitungsabzweigklemme, verbunden sind.

11. System nach Anspruch 10,
**dadurch gekennzeichnet,**
**dass** die Klemmleiste an die Basisplattform oder/und einer Hutprofilschiene in einem Anschlussraum koppelbar ist.

12. System nach einem der Ansprüche 9 bis 11,
**dadurch gekennzeichnet,**
**dass** die starren Anschlussleiter ein mit einem weiteren Anschlussleiter verbindbares Kontaktstück der Klemmleiste bilden.

13. System nach einem der Ansprüche 1 bis 12,
**dadurch gekennzeichnet,**
**dass** die Aufnahmebaugruppe (6) mit sowohl nach oben als auch nach unten von der Baugruppe wegführenden Leitern (11,12) vorgefertigt ist.

14. System nach einem der Ansprüche 1 bis 13,
**dadurch gekennzeichnet,**
**dass** die starren Anschlussleiter unmittelbar in Kontakt mit einem Kontaktstift des Stromzählers kommen.

## Claims

1. Connection system for electronic electricity meters (4, 5) with a base platform (7) and a receiving assembly (6) for the electricity meter (4, 5), mountable on the base platform (7) as a complete unit, wherein the receiving assembly (6) comprises all elements necessary for the electrical and mechanical coupling of the electricity meter (4, 5),
**characterised in that**
the base platform (7) is formed by a section (1) of a meter box installation, comprising a further section (2,3) each above and below the base platform (7), wherein the further sections (2, 3) form an upper and a lower connection space, **in that** the receiving assembly (6) is pre-fabricated with connection conductors (11, 12) to be routed behind the base platform (7) and into both connection spaces, and **in that** the connection conductors (11, 12) are rigid connection conductors (11, 12) corresponding to the connection geometry.

2. System according to claim 1,
**characterised in that**
a seat or several seats for receiving a receiving assembly (6) each is or are formed on the base platform.

3. System according to claim 1 or 2,
**characterised in that**
the base platform (7) comprises a part (13) that can be broken off or removed for forming a seat.

4. System according to claims 1 to 3,
**characterised in that**
the receiving assembly (6, 6a) can be mounted on the base platform from the rear and/or the front of the base platform (7, 7a).

5. System according to one of the claims 1 to 4,
**characterised in that**
the receiving assembly (6) can be attached, preferably arrested, onto the base platform (7).

6. System according to one of the claims 1 to 5,
**characterised in that**
means (16, 17) for securing the receiving assembly (6) in its mounting position on the base platform (7) are provided.

7. System according to one of the claims 1 to 6,
**characterised in that**
an element forming the security comprises means (18) for removing the receiving assembly.

8. System according to one of the claims 5 to 7,
**characterised in that**
an element (10) forming the arresting connection comprises means (18) for disconnecting the arresting connection.

9. System according to claim 7 or 8,
**characterised in that**
the element (10) is blocked by the electricity meter (4).

10. System according to one of the claims 1 to 9,
**characterised in that**
the rigid conductors of the pre-fabricated receiving assembly are connected to a terminal strip, in particular a main line branch terminal.

11. System according to claim 10,
**characterised in that**
the terminal strip can be coupled to the base platform and/or a top-hat rail in a connection space.

12. System according to one of the claims 9 to 11,
**characterised in that**
the rigid connection conductors form a contact piece of the terminal strip that can be connected to a further connection conductor.

13. System according to one of the claims 1 to 12,
**characterised in that**
the receiving assembly (6) is pre-fabricated with conductors (11, 12) leading away from the assembly in an upward as well as a downward direction.

14. System according to one of the claims 1 to 13,
**characterised in that**
the rigid connection conductors come into direct contact with the contact pin of the electricity meter.

## Revendications

1. Système de raccordement pour compteurs d'électricité électroniques (4, 5) comprenant une plateforme de base (7) et un module de réception (6) pour le compteur d'électricité (4, 5) qui peut être monté sur la plateforme de base (7) comme un ensemble, le module de réception (6) comportant tous les éléments nécessaires pour l'accouplement électrique et mécanique du compteur d'électricité (4, 5),
**caractérisé en ce**
**que** la plateforme de base (7) est formée par une partie (1) d'une installation d'armoire de compteur qui comporte une autre partie (2) au-dessus et une autre partie (3) au-dessous de la plateforme de base (7), les autres parties (2, 3) formant un espace de raccordement supérieur et un espace de raccordement inférieur, que le module de réception (6) est préfabriqué avec des conducteurs de raccordement (11, 12) à poser derrière la plateforme de base (7) et à conduire dans les deux espaces de raccordement, et que les conducteurs de raccordement (11, 12) sont des conducteurs de raccordement (11, 12) rigides, préformés d'une manière correspondante à la géométrie de raccordement.

2. Système selon la revendication 1,
**caractérisé en ce**
**qu'**un siège ou plusieurs sièges pour la réception chacun d'un module de réception (6) est ou sont formé(s) sur la plateforme de base.

3. Système selon l'une des revendications 1 ou 2,
**caractérisé en ce**
**que** la plateforme de base (7) comporte une partie (13) arrachable ou détachable destinée à former un siège.

4. Système selon l'une des revendications 1 à 3,
**caractérisé en ce**
**que** le module de réception (6, 6a) peut être monté sur la plateforme de base par le côté arrière et/ou le côté avant de la plateforme de base (7, 7a).

5. Système selon l'une des revendications 1 à 4,
**caractérisé en ce**
**que** le module de réception (6) est emboîtable, de préférence par encliquetage, sur la plateforme de base (7).

6. Système selon l'une des revendications 1 à 5,
**caractérisé en ce**
**que** des dispositifs (16, 17) sont prévus pour maintenir le module de réception (6) dans sa position de montage sur la plateforme de base (7).

7. Système selon l'une des revendications 1 à 6,
**caractérisé en ce**
**qu'**un élément formant le maintien comprend des dispositifs (18) permettant de démonter le module de réception.

8. Système selon l'une des revendications 5 à 7,
**caractérisé en ce**
**qu'**un élément (10) formant la liaison par encliquetage comporte des dispositifs (18) permettant de libérer la liaison par encliquetage.

9. Système selon l'une des revendications 7 ou 8,
**caractérisé en ce**
**que** l'élément (10) est bloqué par le compteur d'électricité (4).

10. Système selon l'une des revendications 1 à 9,
**caractérisé en ce**
**que** les conducteurs rigides du module de réception préfabriqué sont reliés à une réglette à bornes, en particulier une borne de dérivation de ligne principale.

11. Système selon la revendication 10,
**caractérisé en ce**
**que** la réglette à bornes peut être accouplée à la plateforme de base et/ou à un rail à profil en chapeau dans un espace de raccordement.

12. Système selon l'une des revendications 9 à 11,
**caractérisé en ce**
**que** les conducteurs de raccordement rigides forment une pièce de contact de la réglette à bornes pouvant être reliée à un autre conducteur de raccordement.

13. Système selon l'une des revendications 1 à 12,
**caractérisé en ce**
**que** le module de réception (6) est préfabriqué avec des conducteurs (11, 12) partant du module aussi bien vers le haut que vers le bas.

14. Système selon l'une des revendications 1 à 13,
**caractérisé en ce**
**que** les conducteurs de raccordement rigides viennent directement en contact avec une broche de contact du compteur d'électricité.
